# EUROPÄISCHE PATENTANMELDUNG

(11) **EP 0 827 201 A2**
(43) Veröffentlichungstag der Anmeldung: **04.03.1998**
(21) Anmeldenummer: 97112380.7
(22) Anmeldetag: 18.07.1997
(51) Int. Cl.: H01L 25/18

(54) **Leistungs-Halbleiterbauelement**

(30) Priorität: 02.09.1996 DE 19635582
(71) Anmelder: SIEMENS AKTIENGESELLSCHAFT, 80333 München (DE)
(72) Erfinder: Lenz, Michael, 85604 Zorneding (BE)

(57) **Zusammenfassung**

Das erfindungsgemäße Leistungs-Halbleiterbauelement weist einen ersten Chip auf, der einen vertikalen ersten Transistor enthält. Desweiteren ist ein zweiter Chip mit einem zweiten vertikalen Transistor vorgesehen, der deerart auf dem ersten Chip montiert ist, daß die Laststrecken der beiden Transistoren in Reihe geschaltet sind. Die Anordnung läßt sich auf einfache Weise zur Vollbrücke erweitern.

## Beschreibung

Die Erfindung betrifft ein Leistunds-Halbleiterbauelement.

Insbesondere werden derartige Bauelemente bei der Entwicklung von kostengünstigen zuverlässigen Anordnungen zum Treiben von Gleichstrommotoren für Ströme von 10 bis ca. 50 A benötigt. Die Anwendung derartiger Bauelemente sind hauptsächlich im Automobilbereich z.B. bei Fensterhebern, Sitzverstellung, Scheibenwischer, Schiebedach usw. von Nutzen. Für die anzusteuernden Gleichstrommotoren benötigt man eine sogenannte H-Brückenkonfiguration. Diese stellt eine Vollbrücke mit vier Schaltern dar, wobei je zwei in Serie zwischen die Speisespannung und Masse geschaltet sind. Zwischen den Verbindungspunkten der Schalter wird der Gleichstrommotor geschaltet. So kann die Speisespannung bidirektional an den Motor angeschaltet werden. Ein einzelner Zweig dieser Anordnung wird auch als Halbbrücke bezeichnet. Der Restwiderstand der Schalter verursacht Verlustleistung und beeinträchtigt so den Wirkungsgrad des Systems.

Fur relativ kleine Motorströme läßt sich die Brückenkonfiguration monolithisch integrieren. Man benutzt dazu vorzugsweise sogenannte Mischtechnologien, die es erlauben, analoge und digitale Zusatzfunktionen zusammen mit D-MOS-Leistungsschalttransistoren monolithisch zu integrieren. Wegen des relativ hohen Durchlaßwiderstands R_{DSON} bleibt der Laststrom bei vertretbaren Verlustleistungen für diese Strukturen unter ca. 10 A. der Grund für die relativ hohen Durchlaßwiderstände ist im lateralen Stromfluß und zweier relativ hochohmiger Bondverbindungen zu suchen. Ein derartiges Bauelement ist aus dem Katalog der Firma Siliconics, Power Products 1994 auf Seite 1-93 beschrieben.

Bei höheren Stromwerten werden daher heute immer noch elektromechanische Relais eingesetzt. Diese Bauteile haben jedoch Nachteile wie z.B. eine niedrige Zuverlässigkeit, eine begrenzte Lebensdauer, sie sind schlecht zu verarbeiten und weder schwingungsfest noch gerauscharm. All diese Nachteile können mit heute verfügbaren sogenannten vertikalen Technologien, bei denen nur noch eine einzige Bondverbindung benötigt wird, vermieden werden. Bei dieser Technologie wird ein Halbleiterchip auf einer Kühlfläche montiert, welche gleichzeitig als Drainanschluß dient und dadurch eine hochohmige Bondverbindung einspart. Die Einschaltwiderstände bei einer derartigen Technologie liegt daher bei äußerst niedrigen Werten.

Will man mit diesen Bauelementen einen Brückenantrieb realisieren, werden mehrere Kühlflächen die galvanisch getrennt sein müssen benötigt. Auf keinen Fall kann eine Brücke oder auch nur eine Halbbrücke monolithisch integriert werden. Lediglich die beiden High-Side-Schalter können auf einem Chip hergestellt werden, da die Chiprückseiten die jeweiligen Drainanschlusse sind. So kommt man für eine oben erwähnte H-Brückenkonfiguration auf drei Chips, die auf drei getrennten Kühlflächen montiert sind. Diese sind z.B. in einem Gehäuse mit relativ hohem Wärmewiderstand untergebracht. Die Brückenschaltung ist deshalb zwar für hohe Pulsströme aber nur für kleine Dauerströme brauchbar. Gehäuse mit niedrigen Wärmewiderständen sind sehr teuer und setzen sich deshalb nicht durch. Ein Aufbau auf Keramik- oder anderen Substraten ist zwar denkbar aber derzeit ebenfalls zu teuer. Als billigste Lösung gilt das Zusammenschalten diskreter Elemente, d.h. eines Doppel-High-Side-Schalters und zweier Low-Side-Schalter.

Aufgabe der vorliegenden Erfindung ist es, ein Leistungs-Halbleiterbauelement anzugeben, mit dem sowohl eine integrierte Halbbrücke wie auch eine integrierte Vollbrücke realisierbar ist, die die zuvor genannten Nachteile nicht aufweist.

Diese Aufgabe wird durch den kennzeichnenden Teil des Anspruchs 1 gelöst. Weiterbildungen sind Kennzeichen der Unteransprüche.

Vorteil der Anordnung ist, daß eine Halbbrücke durch die erfindungsgemäße Chip-on-Chip-Montage derart realisiert wird, daß die Laststrecken zweier Leistungs-Transistoren durch die Montage in Reihe geschaltet werden. Eine derartige Anordnung läßt sich auf einfache Weise zu einer integrierten Vollbrücke ergänzen.

Durch die Chip-on-Chip-Montage kann die Temperatur der aufmontierten Chips durch den darunterliegenden Chip erfaßt werden. Die als Low-Side-Schalter dienenden aufmontierten Halbleiterschalter können daher ohne Eigenintelligenz ausgelegt werden, wodurch die Kosten zur Herstellung des Bauelements vermindert werden.

Die Erfindung wird nachfolgend anhand von zwei Figuren näher erläutert. Es zeigen
- Figur 1: ein Prinzipschaltbild einer erfindungsgemäßen Vollbrücke mit Ersatzschaltbild, und
- Figur 2: eine Schnittdarstellung eines erfindungsgemäßen Halbleiterbauelements.

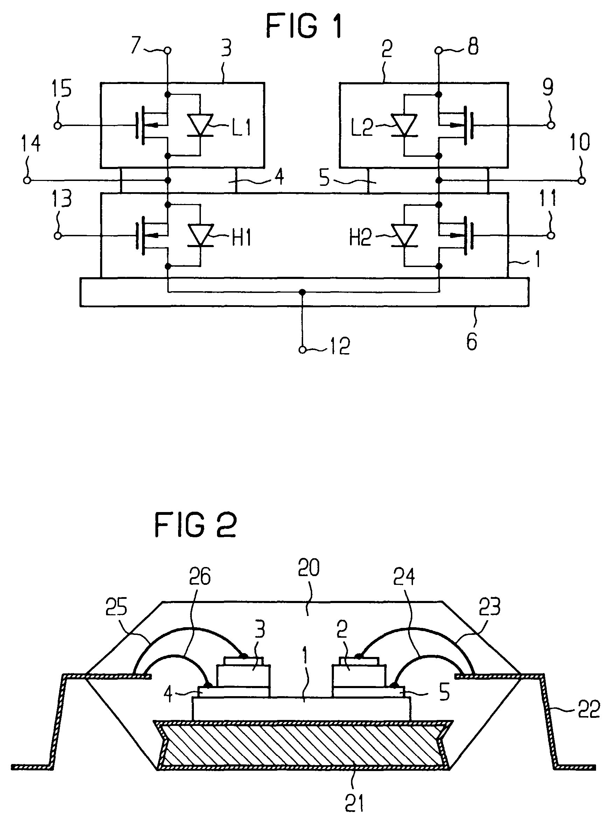

In Figur 1 ist eine schematische Darstellung des erfindungsgemäßen Halbleiterbauelements dargestellt. Mit 6 ist eine Kühlfläche bezeichnet, auf der ein Chip 1 montiert ist. Dieser Chip 1 enthält zwei sourceseitig voneinander isolierte Halbleiterschalter H1, H2. Die beiden Drainanschlüsse der Halbleiterschalter H1 und H2 bilden die Chiprückseite. Der Chip wird mit der Rückseite auf eine Kühlfläche 6 montiert und ist über einen Anschluß 12 kontaktierbar. Auf den Sourceflächen der beiden Transistoren H1 und H2 werden dann durch Löten, Sintern oder sonstige Montageverfahren zwei weitere Chips 2 und 3 aufgebracht, die jeweils einen weiteren Leistungstransistor L1 und L2 enthalten. Durch diese Montage wird der Drainbereich des Transistors L1 mit dem Sourcebereich des Transistors H1 und der Drainbereich des Transistors L2 mit dem Sourcebereich des Transistors H2 verbunden. Der Knotenpunkt dieser jeweiligen Verbindungen 4, 5 ist über jeweilige Anschlüsse 10 bzw. 14 extern anschließbar. Die jeweiligen Sourcebereiche der Transistoren L1 und L2 sind über externe Anschlüsse 7 und 8 ebenfalls z.B. durch Bondung kontaktierbar. Die Anschlüsse 9, 11, 13 und 15 zur Ansteuerung der jeweiligen Transistoren der H1, H2, L1, L2 der Vollbrücke sind in bekannter Weise anschließbar.

Figur 2 zeigt eine Realisierungsmöglichkeit einer derartigen erfindungsgemäßen Anordnung in einem Gehäuse. Mit 20 ist z.B. ein oberflächenmontierbares Gehäuse mit jeweiligen externen Anschlüssen 22 dargestellt. Innerhalb des Gehäuses ist eine Aufnahmevorrichtung 21 vorgesehen, die gleichzeitig als Kühlkörper und daher als Kontaktbereich für den Drainanschluß und als Träger der gesamten Anordnung dienen kann. Auf dieser Montageeinrichtung 21 ist der erste Halbleiterchip in bekannter Weise durch Löten, Sintern oder dergleichen befestigt. Die beiden an der Oberfläche des Chips 1 befindlichen Sourceflächen der Transistoren H1 und H2 sind größer als die auf ihnen montierten zweiten und dritten Chips 2, 3. Dadurch kann die Kontaktierungsfläche 4 bzw. 5 von oben auf einfache Weise mittels Bonddrähte 24 und 26 mit den außen zugänglichen Anschlüssen 22 kontaktiert werden. Die Sourceflächen der Halbleiterchips 2 und 3 werden ebenfalls von oben durch Bonddrähte 23 und 25 mit den jeweiligen außen zugänglichen Anschlußpins 22 verbunden.

Für eine derartige Anordnung gilt als Bedingung, daß die die Low-Side-Transistoren enthaltenen Chips 2 und 3 in ihrer Drainanschluß-Grundfläche kleiner sind als die jeweiligen Sourcekontaktierflächen der High-Side-Schalter H1 und H2 im ersten Chip 1. Des weiteren muß die Verbindung 4, 5 zwischen den Chips 1 und 2 bzw. 3 dick genug sein, um lateral Strom führen zu können. Der Grund hierfür ist, daß der Strom entweder über die Leitung 26 bzw. 24 zum Drain der Transistoren L1 bzw. L2 unter dem jeweiligen Chip 2 oder 3 fließt oder zumindest teilweise vom Source der Transistoren H1 bzw. H2 unter dem Chip 2 bzw. 3 lateral zu den Drähten 24 bzw. 26 fließt.

Bei Betrieb als Motortreiber sind die Schalttransistoren L1, L2, H1, H2 jeweils über Kreuz unter Last. Diese Tatsache hat den Vorteil, daß nie zwei übereinanderliegende Transistoren L1 und H1 bzw. L2 und H2 gleichzeitig belastet werden. Ferner kann der unten liegende High-Side-Schalter H1 bzw. H2 die Temperatur des darüberliegenden Low-Side-Transistors L1 bzw. L2 fühlen. Daher kann der Low-Side-Transistor L1 bzw. L2 ohne Eigenintelligenz, d.h. z.B. ohne Schutzschaltung gegen Übertemperatur bzw. Überlast usw., ausgelegt werden. Auf diese Weise kann der Low-Side-Schalter in einem preiswerten auf minimalen Einschaltwiderstand optimierten Prozeß hergestellt werden. Die Bedingung, gemäß Figur 2, für eine besonders einfache von oben durchführbare Bondverbindung, daß die Grundfläche der Chips 2 und 3 kleiner ist als die der jeweiligen Sourcekontaktierfläche der Transistoren im Chip 1 kann dann leicht erfüllt werden, da die High-Side-Schalter im Chip 1 mit einem aufwendigeren Prozeß hergestellt werden, da zumindest massebezogene Logik-Eingänge und somit eine Ladungspumpe und ein entsprechender Pegelwandler benötigt werden. Des weiteren können die Transistoren H1 und H2 im Chip 1 mit Schutzschaltungen gegen Übertemperatur und Überlast usw. versehen werden.

Die erfindungsgemäße Anordnung ist sowohl für Vollbrücken gemäß Figur 1 und Figur 2 wie auch für Halbbrücken, bei denen z.B. die Transistoren H2 und L2 entfallen, anwendbar. Insbesondere ist die Realisierung einer Halbbrücke sinnvoll, wenn die Verlustleistung einer vollständigen H-Brückenschaltung in einem preiswerten Gehäuse nicht realisierbar ist, da die Abmessungen preisgünstiger Gehäuse überschritten werden, oder die Temperaturbedingungen durch das Gehäuse nicht erfüllt werden können.

## Patentansprüche

1. Leistungs-Halbleiterbauelement mit einem ersten Chip (1), der einen vertikalen ersten Transistor (H1) enthält, wobei der erste Chip (1) auf einer Kühlfläche (6) montiert ist, einem zweiten Chip (3), der einen vertikalen zweiten Transistor (L1) enthält, wobei der zweite Chip (3) derart auf dem ersten Chip (1) montiert ist, daß die Laststrecken des ersten und zweiten Transistors (L1,H1) in Reihe geschaltet sind.

2. Leistungs-Halbleiterbauelement nach Anspruch 1,
**dadurch gekennzeichnet,** daß der erste Chip (1) wenigstens einen weiteren vom ersten Transistor (H1) sourceseitig isolierten dritten Transistor (H2) enthält, daß wenigstens ein weiterer dritter Chip (2) vorgesehen ist, der einen vertikalen vierten Transistor (L2) enthält, wobei der dritte Chip (2) derart auf dem ersten Chip (1) montiert ist, daß die Laststrecken des dritten und vierten Transistors (L2,H2) in Reihe geschaltet sind.

3. Leistungs-Halbleiterbauelement gemäß einem der vorhergehenden Ansprüche,
**dadurch gekennzeichnet,** daß die effektive Sourceanschlußfläche des ersten Transistors (H1) auf dem Chip (1) größer ist als die effektive Drainanschlußfläche des zweiten bzw. dritten Chips (2,3).

4. Leistungs-Halbleiterbauelement nach einem der vorhergehenden Ansprüche,
**dadurch gekennzeichnet,** daß der erste Chip (1) des weiteren eine Ansteuerschaltung für die Leistungs-Transistoren (H1,H2) aufweist.

5. Leistungs-Halbleiterbauelement nach einem der vorhergehenden Ansprüche,
**dadurch gekennzeichnet,** daß der erste Chip (1) wenigstens eine Schutzschaltung für die Leistungs-Transistoren (H1,H2) aufweist.
